(19) **Europäisches Patentamt / European Patent Office / Office européen des brevets**

(11) **EP 1 839 343 B1**

(12) **EUROPEAN PATENT SPECIFICATION**

(45) Date of publication and mention of the grant of the patent:
**24.06.2009 Bulletin 2009/26**

(21) Application number: **06701208.8**

(22) Date of filing: **10.01.2006**

(51) Int Cl.:
**H01L 31/101** (2006.01)  **H01L 27/146** (2006.01)

(86) International application number:
**PCT/EP2006/050103**

(87) International publication number:
**WO 2006/074990 (20.07.2006 Gazette 2006/29)**

(54) **SEMICONDUCTOR PHOTODIODE AND METHOD OF MAKING**

HALBLEITERPHOTODIODE UND HERSTELLUNGSVERFAHREN DAFÜR

PHOTODIODE À SEMICONDUCTEUR ET PROCÉDÉ DE FABRICATION

(84) Designated Contracting States:
**AT BE BG CH CY CZ DE DK EE ES FI FR GB GR HU IE IS IT LI LT LU LV MC NL PL PT RO SE SI SK TR**

(30) Priority: **11.01.2005 EP 05100128**

(43) Date of publication of application:
**03.10.2007 Bulletin 2007/40**

(73) Proprietor: **ECOLE POLYTECHNIQUE FEDERALE DE LAUSANNE EPFL - STI - IMM - LMIS3 1015 Lausanne (CH)**

(72) Inventors:
• **POPOVIC, Radivoje**
**CH-1025 St-Sulpice (CH)**
• **XIAO, Zhen**
**CH-1018 Lausanne (CH)**

(74) Representative: **Falk, Urs**
**Patentanwaltsbüro Dr. Urs Falk**
**Eichholzweg 9A**
**6312 Steinhausen (CH)**

(56) References cited:
EP-A- 0 736 912        US-A- 4 468 684
US-A- 4 837 607        US-A1- 2002 066 860
US-B1- 6 897 430

• BIBER A ET AL: "AVALANCHE PHOTODIODE IMAGE SENSOR IN STANDARD SILICON BICMOS TECHNOLOGY" SENSORS AND ACTUATORS A, ELSEVIER SEQUOIA S.A., LAUSANNE, CH, vol. A90, no. 1/2, 1 May 2001 (2001-05-01), pages 82-88, XP001150248 ISSN: 0924-4247
• ROCHAS A ET AL: "Single photon detector fabricated in a complementary metal–oxide–semiconductor high-voltage technology" REVIEW OF SCIENTIFIC INSTRUMENTS, AMERICAN INSTITUTE OF PHYSICS, US, vol. 74, no. 7, July 2003 (2003-07), pages 3263-3270, XP012040912 ISSN: 0034-6748

**Description**

FIELD OF THE INVENTION

The invention concerns a semiconductor photodiode for the detection of photons or light and a process for making a semiconductor photodiode.

BACKGROUND OF THE INVENTION

A diode is formed between two areas of semiconductor material of different conductivity type, namely p-type material and n-type material. Besides many other applications, diodes can be used for the detection of photons or light and are widely used in electronic cameras, flame detectors, 3D time-of-flight sensors, single photon counters for spectroscopy, etc.

In order to achieve high gain and high sensitivity a photodiode is operated biased with a high reverse voltage. Such a photodiode is called an avalanche photodiode (APD). The avalanche photodiode can be operated with a bias voltage below breakdown or even with a bias voltage above breakdown, the latter operating mode is called Geiger mode.

For the fabrication of APDs, the so-called "reach-through" device architecture is presently dominant in the market. These devices have large depletion regions, deep junction formation, and require high bias voltages (in excess of 200V). The main drawback of these devices is their incompatibility with standard electronics which results in bulky and expensive products.

A further approach for developing avalanche photodiodes uses planar technologies. One of the examples is described in the article "Avalanche photodiode image sensor in standard silicon BICMOS technology" of Biber A et al that was published in SENSORS AND ACTUATORS A, ELSEVIER SEQUOIA S.A., LAUSANNE, CH, vol. A90, no. 1/2 on 1 May 2001, pages 82-88, XP001150248 ISSN: 0924-4247. The photodiode has a cylindrical geometry and is surrounded by a guard ring. One of the latest examples is described in the article "Monolithically integrated avalanche photodiode and transimpedance amplifier in a hybrid bulk / SOI CMOS process", Electronic Letters, Vol. 39, No. 4, February 2003, pages 391-392. It presented an integrated photoreceiver having avalanche photodiodes. However, these photodiodes, although being compatible with the well-known and widespread CMOS technologies, require custom process stages and extra masks. An avalanche photodiode with a guard ring is also known from the article "Single photon detector fabricated in a complementary metal-oxide-semiconductor high-voltage technology" of Rochas A et al. that was published in REVIEW OF SCIENTIFIC INSTRUMENTS, AMERICAN INSTITUTE OF PHYSICS, US, vol. 74, no. 7, July 2003, pages 3263-3270, XP012040912 ISSN: 0034-6748. The guard ring serves to protect the periphery of the diode region in order to avoid breakdown at the corners of the junction.

Another approach for integrating avalanche photodiodes into standard CMOS technology is disclosed in the US patent no. 6376321. An array of such photodiodes together with readout electronics is described in the article "First fully integrated 2-D array of single-photon detectors in standard CMOS technology", IEEE Photonics Technology Letters, Vol.15, No.7, 2003, pp. 963-965. The drawback of this photodiode is its small fill factor as a result of the complex guard ring structure. In addition, the leakage current is too high, which limits the size of the photodiode to around 20 micrometer in diameter only.

Yet another innovation published recently (WO 03/003476) aims to improve the defect density and hence the dark count rate by constructing a large photodectector composed of an array of small photodiodes. However, the dark counts still increase linearly with the area of the device, which sets a limit on the size of the photodetector. Besides, the large capacitance associated with the large area makes the quenching and recharging more difficult and lengthens the dead time. More importantly, the spacing required between the small photodiodes deteriorates the efficiency of the photodectector.

US 2002/0066860 discloses an imaging array which includes a guard diode to reduce leakage current. US 4468684 discloses a CCD array having complementary adjacent channels.

BRIEF DESCRIPTION OF THE INVENTION

The object of the invention is to develop an improved avalanche photodiode that is compatible with a CMOS process, preferably with a CMOS process with high voltage capability as recited in claim 1.

In the following the term "avalanche photodiode" means a diode formed as a pn-junction between n-type semiconductor material and p-type semiconductor material and operated biased with a reverse voltage for making use of the avalanche effect. The avalanche effect consists in that a single photon creates an electron hole pair in the pn-junction, that the electron or hole creates a further electron hole pair which also creates a further electron hole pair, etc. Thus each photon produces a lot of electrons and holes which results in a current that can be measured.

The avalanche photodiode of the present invention consists of an essentially hemispherical region of p-type material arranged at and made by diffusion from the surface of an n-type region, or vice versa, an essentially hemispherical region of n-type material arranged at and made by diffusion from the surface of a p-type region. As a result of this structure a uniform pn-junction is formed that has the advantage that it prevents premature breakdown without the need to add any special layer or complex diffusion guard ring structures. A further advantage is its high efficiency because no or only a minimum part of the available area gets lost for measures taken for increasing the breakdown voltage.

The three-dimensional form of the diffused region is not exactly but approximately hemispherical because the lateral diffusion rate is slightly smaller than the diffusion rate into the depth of the material. Generally the lateral diffusion width is about 80% of the diffusion depth.

For the production of a hemispherical region of a second conductivity type embedded into a region of a first conductivity type by the well-known processes of implantation and diffusion, the lateral dimensions of the window in the implantation mask are selected much smaller, preferably five to eight times smaller, than the junction depth of the resulting region. The diffusion process is then nearly isotropic and fed from a point source. To achieve this goal, the window in the implantation mask shall be sized not larger than the diffusion length of the ions. This is in contrast to the state of the art, where the implantation window always has a size that is larger and even often much larger than the diffusion length of the ions, so that a conventional planar junction results.

In a first embodiment of the invention the region of the first conductivity type has a uniform conductivity, e.g. if the region of the first conductivity type is an epitaxially grown layer. In a second embodiment of the invention the region of the first conductivity type has also a hemispherical structure resulting from an implantation and diffusion process like the hemispherical structure of the region of the second conductivity type. Here the conductivity within the diffused region is not uniform but the doping concentration has (radially seen) the same gradient. So in both cases the radial variation of the doping concentration is approximately the same at the whole area of the pn-junction formed between the regions of the first and second conductivity type. This means that the pn-junction has everywhere the same doping profile and is therefore uniform: For this reason breakdown may occur anywhere in the pn-junction with the same probability.

However, a mini guard ring can be added to reduce the trapping effects in the surface states which contribute to afterpulses. Afterpulses are fault counts generated by electrons or holes trapped during an avalanche process. The $Si/SiO_2$ interface is particularly prone to trap carriers due to the surface states present there. These trapped electrons and holes may be released after a trapping time, and these released electrons and holes may initiate a new avalanche process as far as the photodiode has been properly recharged. This pulse is therefore a fault as it is not a response from the actual illumination, but rather remains of the previous avalanche effect, therefore it is called "afterpulse". The mini guard ring is a very small and shallow diffusion ring of the same conductivity type as the hemispherical region and serves to exclude the very near surface region from the avalanche process. The mini guard ring has a junction depth that is at least two times smaller than the junction depth of the photodiode so the area occupied by the mini guard ring is rather small and the photodiode structure remains compact and area efficient. However, if the number of implanted ions for producing the mini guard ring is too small, the resulting mini guard ring is an area still having the first conductivity type, but then of course the conductivity of this area is reduced.

Alternatively, a polysilicon or metal field plate surrounding the photodiode may be employed to avoid surface trapping during the avalanche process. Preferably, polysilicon is used and the polysilicon field plate is electrically connected in series to the pn-junction, thus also making use of the polysilicon field plate as an internal resistor that limits the maximum allowable current flowing through the photodiode when the avalanche effect occurs.

Preferably, a plurality of photodiode as recited in claim 7 are placed next to each other and electrically connected in parallel to form a single avalanche photodetector. The photodiodes thus form a one- or two-dimensional array. Thermal noise creates dark current peaks that are statistically uniformly distributed among different photodiodes whereas light shining uniformly on the avalanche photodetector creates a signal current peak in each photodiode that sum up to a global signal current peak. By using a comparator defining a threshold value the global signal current peaks can be discriminated from the weaker dark current peaks. Furthermore, the quenching and recharging of each single photodiode occurs individually. Therefore the time constant stays rather small even for an avalanche photodetector composed of many photodiodes.

In an array of photodiodes, one photodiode may use its neighboring photodiodes as guard ring for premature breakdown prevention. It is based on the principle that the lateral diffusion of the neighboring photodiode implantation helps to reduce the electrical field at the periphery near the surface. In addition, the distance between neighboring photodiodes can be optimized so that the depletion regions touch each other before breakdown happens. This prevents the avalanche effect at the periphery below the surface.

Photodiodes arranged in a two-dimensional array may also be used for 2D or 3D imaging applications. In this case each photodiode functions as a pixel and is combined with an in-pixel electronic circuit. As a result of the simple structure of the photodiode, the fill factor is primarily limited by the size of the electronic circuit. Manufacturing methods to realise the invention are recited in claims 11 and 13. Further advantageous embodiments are recited in claims 12 and 14.

BRIEF DESCRIPTION OF THE DRAWING FIGURES

The accompanying drawings, which are incorporated into and constitute a part of this specification, illustrate one or more embodiments of the present invention and, together with the detailed description, serve to explain the principles and implementations of the invention. The figures are not to scale. In the drawings:

Figs. 1, 2 illustrate two examples for the manufacture of a photodiode with a hemispherical structure,

Figs. 3, 4 illustrate two examples for the manufacture of a photodiode with a hemispherical structure and a mini guard ring,

Fig. 5 show a plan view of an implantation mask for producing the mini guard ring,

Figs. 6, 7, 8 show a cross section and plan views of a photodiode having a polysilicon or metal field plate,

Figs. 9, 10 show a photodetector composed of a plurality of individual photodiodes,

Figs. 11, 12 illustrate the use of the photodiode for 2D or 3D imaging applications,

Figs. 13, 14 show a circuit diagram and an implementation of the circuit diagram in CMOS technology, and

Figs. 15-18 illustrate another concept for increasing the breakdown voltage of photodiodes arranged in a two-dimensional array.

DETAILED DESCRIPTION OF THE INVENTION

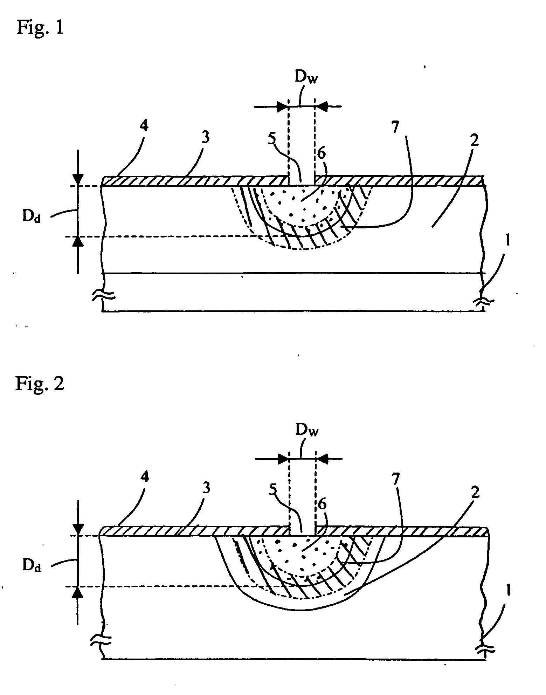

The photodiode according to the invention has a unique structure designed with the intention to achieve the same electrical field throughout the whole pn-junction so that breakdown occurs with the same probability at any place of the pn-junction. This is achieved with a three dimensionally symmetrical structure, namely a hemispherical structure. The photodiode is preferably manufactured in a standard CMOS technology having high voltage capability. Such a CMOS technology comprises p-doped and/or n-doped regions with deep diffusion of e.g. 5 micrometers or a for example epitaxially grown layer of approximately uniform doping. Fig. 1 illustrates the process steps for making a pn-juction having approximately this structure.

Fig. 1 shows a cross section of a semiconductor wafer 1. The semiconductor wafer 1 or at least a region 2 or layer below the surface 3 of the wafer 1 consists of semiconductor material of a first conductivity type. Preferably, the doping and hence conductivity of the region 2 is uniform. The surface 3 of the wafer 1 is covered with an implantation mask 4 having openings or windows 5 for producing relatively deep regions of a second conductivity type by implanting ions of the required conductivity type and subsequent long and deep diffusion. After implantation and diffusion regions of a second conductivity type are formed below the windows 5. If the first conductivity type is n-type, then the second conductivity type is p-type. If the first conductivity type is p-type, then the second conductivity type is n-type.

A window 5 is designed for making a photodiode with a hemispherical structure if the conductivity of the region 2 is uniform. According to the invention the size $D_w$ of the window 5, i.e. its lateral dimensions, is selected equal to or smaller than the diffusion length $L_D$ of the ions. The diffusion length $L_D$ depends mainly on the diffusion coefficient D and the diffusion time t and is given by the equation

$$L_D = \sqrt{D(T) * t} \tag{1}.$$

The diffusion coefficient D depends mainly on the temperature T but also on other parameters that characterize the used diffusion process. Further details concerning the diffusion length $L_D$ can for example be taken from the book "Physics of Semiconductor Devices", 2nd edition, 1981, John Wiley & Sons, Inc of S. M. Sze. Practically, the diffusion process can then be considered as a diffusion fed from a point source. The final junction depth $D_d$ will be much larger, typically around five to eight times larger, than the size of the window 5. As a result of this the diffusion profile of a region 6 of the second conductivity type is hemispherical or, for the reasons explained above, at least approximately hemispherical. The form of the window 5 may be circular or square or of any other shape. As its size is much smaller than the junction depth its form has no or negligible influence on the form of the resulting three-dimensional diffusion profile.

If the doping of the region 2 of the first conductivity type is not uniform, e.g. if the region 2 is also a region formed by implantation and diffusion, the resulting geometrical form of the region 6 of the second conductivity type may deviate from the ideal hemispherical form.

In another embodiment of the invention, shown in fig. 2, the region 2 of the first conductivity type is not a layer of uniform conductivity but a region formed by implantation through a window formed in a mask and subsequent diffusion and therefore having a non uniform conductivity. The dimensions of the window are also designed much smaller than the resulting junction depth, so that after implantation and diffusion of ions of the second conductivity type according to the process described with fig. 1 for forming the region 6 a diode with a uniform pn-junction and therefore a uniform electrical field results. The diode is formed according to a process comprising the steps of

- implanting and diffusing ions of a first conductivity type into semiconductor material of a second conductivity type through a first window in a first implantation mask for forming the region 2 of the first conductivity type wherein the lateral dimensions of the first window are equal to or smaller than the diffusion length of the ions of the first conductivity type, and

- implanting and diffusing ions of the second conductivity type into the first region 2 through a second window in a second implantation mask for forming the region 6 of the second conductivity type wherein the lateral dimensions of the second window are equal to or smaller than the diffusion length of the ions of the second conductivity type.

The first and second window are centered with respect to each other.

The boundary of the region 6 and the region 2 form a pn-junction and a depletion zone 7 builds up at the pn-junction. In operation the pn-junction is reverse biased. The size of the depletion zone 7 depends upon the reverse bias voltage. The reverse biased pn-junction serves as photon detecting zone. The reverse bias is selected so high that light shining on the photodiode initiates the avalanche effect.

The implantation mask 4 may be an oxide layer grown on the surface 3 of the wafer 1 or a layer of photoresist deposited on the surface 3 of the wafer 1. In most cases the implantation mask 4 is removed before or after the diffusion step. It is preferred to use a standard CMOS process technology without any modifications. However, if necessary, it is possible to precisely adjust the dose of the implanted ions. Techniques for doing this are well-known.

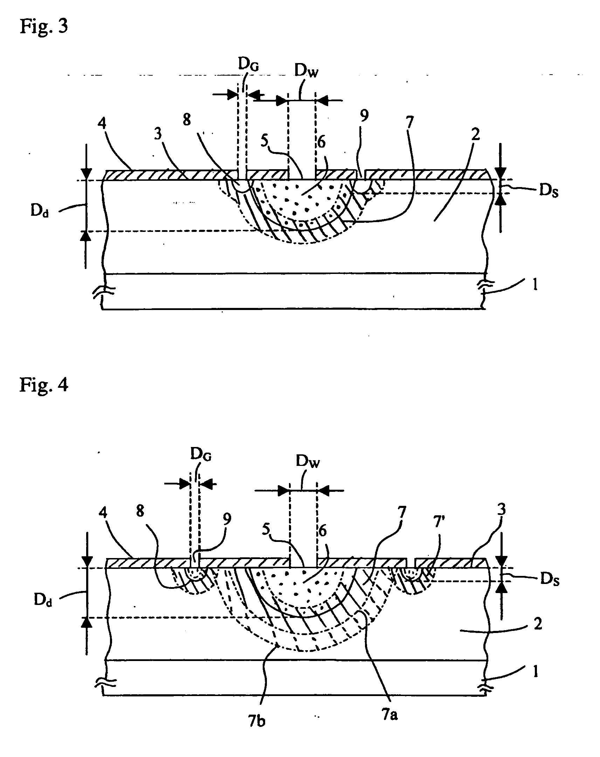

Generally, if no additional measures are taken, breakdown of the invented photodiode still occurs in the very near surface region because unavoidable surface states exist. In order to eliminate this surface breakdown the invention proposes to surround the photodiode with a guard ring. The guard ring may be a conventional diffusion guard ring. However, such a conventional guard ring has the drawback that it occupies a big area and thus reduces the efficiency of the photodiode. The invention therefore proposes to produce a mini guard ring that surrounds the region 6 along its periphery below the surface 3. Figs. 3 and 4 illustrate two examples for the manufacture of the mini guard ring for the diode shown in fig. 1. However, the mini guard ring 8 can also be implemented with the diode shown in fig. 2.

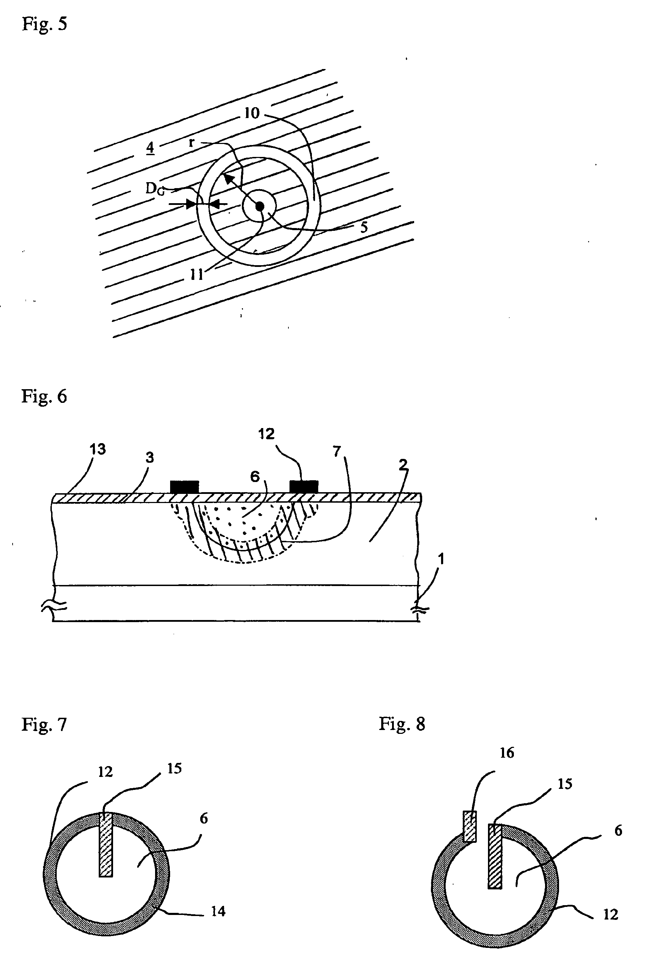

According to a first embodiment, the mini guard ring 8 is made simultaneously with the manufacture of the region 6, i.e. by using the same process steps. The implantation mask 4 has the window 5 and a second, annular window 9. The first window 5 is the same as in the first embodiment illustrated in fig. 1. The second window 9 is a ring shaped stripe 10 centered at the center 11 of the first window 5 as shown in plan view in Fig. 5. The width $D_G$ of the ring-shaped stripe 10 is selected at least two times smaller than the maximum lateral dimension $D_W$ of the first window 5 and at least two times smaller than the diffusion length $L_D$ of the ions of the second conductivity type so that the resulting junction depth $D_S$ of the mini guard ring 8 is smaller than the junction depth $D_d$ of the region 6 by typically a factor of four.

According to a second embodiment, the mini guard ring 8 is made with additional implantation and diffusion process steps allowing further optimization of its geometrical and/or electrical properties. As an example, first the region 6 is formed with an implantation and diffusion step as described above with reference to fig. 1. Afterwards the surface 3 of the wafer 1 is prepared for receiving a second implantation mask having the second window 9. The dose of the implantation can now be selected independently of the dose of the ions implanted in the first window 5. The parameters of the subsequent diffusion step like temperature, atmosphere, diffusion time, etc. can be selected to achieve the optimum geometrical and/or electrical properties of the resulting mini guard ring 8.

The radius r of the ring-shaped stripe 10 is selected so that

(1) the mini diffusion guard ring 8 and the region 6 combine during the diffusion process into one single region of the second conductivity type as shown in fig. 3, or that

(2) the region 6 and the mini guard ring 8 are separated regions of the second conductivity type that do not overlap but that the depletion zone 7' formed between the mini diffusion guard ring 8 and the region 2 of the first conductivity type and the depletion zone 7 formed between the region 6 and the region 2 of the first conductivity type touch each other. The radius r of the ring-shaped stripe 10 is preferably selected so that the depletion zones touch each other when a reverse bias voltage of typically half the breakdown voltage is applied across the pn-junction of the photodiode. This embodiment is shown in fig. 4. Fig. 4 illustrates with dotted line 7a the border of the depletion zone 7 when no reverse voltage is applied to the photodiode: the depletion zones 7 and 7' do not yet touch each other, as well as with dotted line 7b the border of the depletion zone 7 when a reverse voltage of sufficient strength is applied to the photodiode causing the depletion zone 7 to increase so that the depletion zone 7 touches the depletion zone 7'. Typically the reverse voltage needed for the touch lies between the breakdown voltage of the photodiode and half the breakdown voltage.

In all cases, the mini guard ring 8 reduces the electrical field in the depletion zone 7 near the surface 3. The design of the second window 9 as a point source for the diffusion results in a low doped small region at the periphery of the region 6 below and near the surface 3. This increases the breakdown voltage locally below the surface 3 and therefore excludes this area from the avalanche process. Negative effects due to trapping in surface states are greatly reduced and the reliability of the photodiode is increased.

Depending on the parameters, mainly the dose of the implanted ions and the diffusion temperature and diffusion time, the mini guard ring 8 is a region having the same conductivity type as the region 6 of the photodiode or it can be a region having the same conductivity type as the region 2. In the latter case it reduces locally the conductivity of the region 2 and thus the strength of the electrical field in the pn-junction below the surface 3.

As already stated above, a conventional floating diffusion guard ring may be used as well instead of the mini guard ring 8. The conventional floating diffusion guard ring is a ring of the second conductivity type which surrounds the region 6 without overlapping with the region 6. But the depletion zone of the conventional floating guard ring overlaps with the depletion zone 7. The drawback of this solution is that the conventional floating diffusion guard ring requires much more space than the mini guard ring 8 of the invention resulting in a photodiode with much less area efficiency.

Figs. 6, 7 and 8 show a cross section and plan views onto the surface 3 of the wafer 1 to illustrate another possibility to avoid surface trapping, namely the use of a polysilicon or metal field plate 12 instead of the mini guard ring or the conventional floating diffusion guard ring. The field plate 12 is separated from the region 6 by an insulating layer 13, generally by a layer of $SiO_2$. In operation the field plate 12 is biased with a voltage which in case that the hemispherical diffusion region 6 is of n-type is not lower than the voltage at the n-type region 6 and which in case that the hemispherical diffusion region 6 is of p-type is not higher than the voltage at the p-type region 6. The position and width of the field plate 12 are selected so, that in operation the field plate 12 covers at least the area of that part above the depletion zone 7 that extends into the region 2 of the first conductivity type. With the example shown in fig. 7 the polysilicon or metal field plate 12 is a ring 14 that is electrically connected via a metal line 15 with the region 6 of the photodiode. It therefore has the same electrical potential as the region 6. With the example shown in fig. 8 the field plate 12 is still ring shaped, but made of polysilicon and it has two ends separated by the minimal distance allowed by the design rules of the CMOS process. One end is electrically connected via the metal line 15 with the region 6, the other end is connected via a further metal line 16 to an external voltage source. The polysilicon field plate 12 has an internal resistance depending on the width and length of the ring shaped field plate 12 and it is electrically connected in series to the photodiode. This resistance limits the current that can flow when avalanche breakdown occurs.

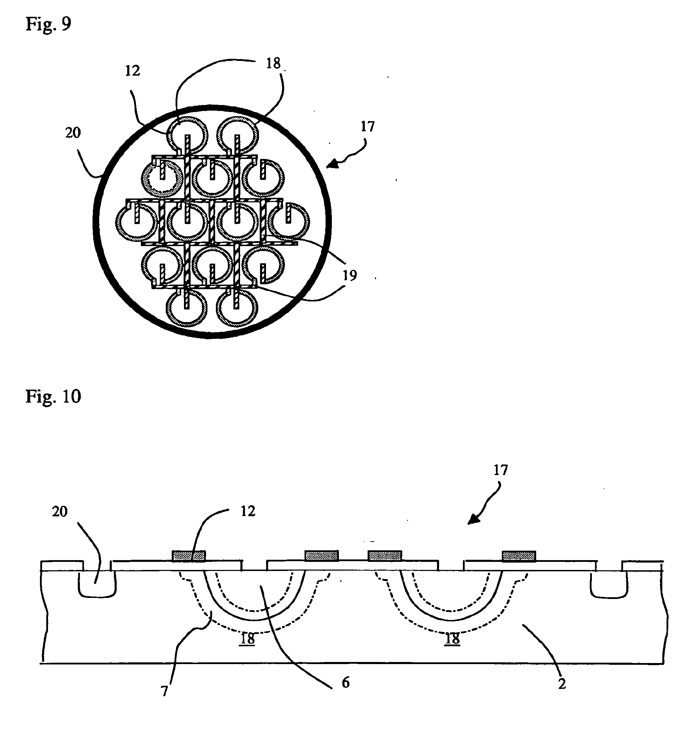

Figs. 9 and 10 show in plan view and in cross-section a photodetector 17 composed of individual photodiodes 18 that are electrically connected in parallel. Each of the photodiodes 18 has the hemispherical structure and a polysilicon field plate 12 having the first end connected in series to the corresponding photodiode 18 as described above and shown in fig. 8. The second ends of the polysilicon field plates 12 are electrically connected by metal lines 19. The photodetector 17 further comprises an ohmic contact region 20 that surrounds the array of the photodiodes 18 and contacts the region 2 of the first conductivity type (fig. 6). In operation the metal lines 19 and the ohmic contact region 20 form the two terminals of the photodetector 17 which are connected to a voltage source for biasing the photodetector 17 with a reverse bias voltage. The photodetector 17 is preferably operated in the Geiger mode, the reverse voltage being for example 5 V higher than the breakdown voltage. Whenever a photon initiates the avalanche effect in one of the individual photodiodes 18, the resistance of its polysilicon field plate 12 limits the maximal current that can flow so that the voltage lying at this photodiode decreases very rapidly to a level slightly below the breakdown voltage where the avalanche effect stops from itself. After the avalanche effect has stopped, the voltage at this photodiode increases again to the reverse voltage supplied by the voltage source. As this quenching and recharging concerns only one photodiode, the time constant for returning to the normal state of operation is rather small and nearly independent on the number of individual photodiodes 18 that form the photodetector 17.

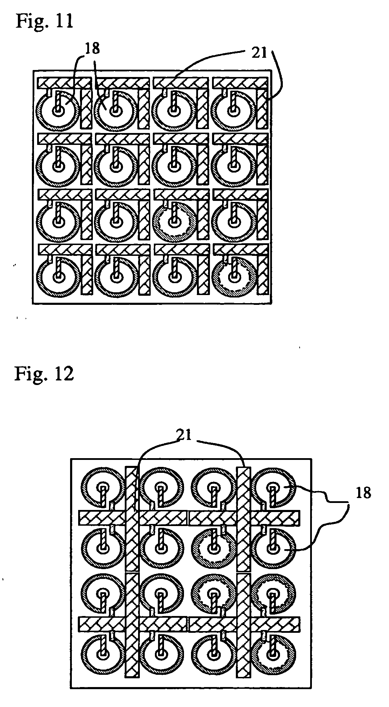

Figs. 11 and 12 illustrate examples for the use of the invented photodiode in 2D or 3D imaging applications where the photodiodes 18 are arranged in a two-dimensional array and where each photodiode 18 is connected to a respective in-pixel electronic circuit 21. The photodiodes 18 each have the hemispherical structure and a polysilicon field plate 12 having the first end connected in series to the corresponding photodiode as described above. The second end of the polysilicon field plate 12 is electrically connected to its in-pixel electronic circuit 21. The structure of the embodiment shown in fig. 11 is compact and dense and due to the simple structure of the photodiode, the fill factor is primarily limited by the area the in-pixel electronic circuit 21 needs. In the example shown in fig. 12 four photodiodes 18 are assigned to one in-pixel electronic circuit 21.

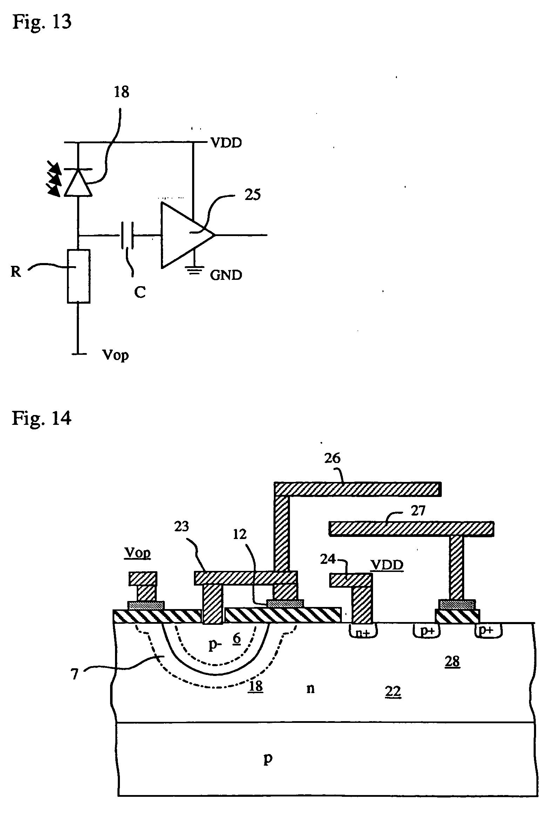

The in-pixel electronic circuit 21 should be simple and occupy as little area as possible. Furthermore, as the photodiodes 18 have to be biased with a voltage in the order of a few ten volts special attention should be drawn to the compatibility with standard 5V or 3.3V electronics. An example of a circuit diagram and its implementation in CMOS technology is shown in Figs. 13 and 14, respectively. The region 2 of figs. 1 and 3 is an n-well 22 and the photodiode 18 is formed as a p-diffused region 6 formed in the n-well 22. The conductivity type is denoted as usual with letters n-, p-, n+ and p+ where the signs - and + denote the relative concentration of the doped ions. The n-well 22 is for example tied to $V_{DD}$= 3.3V. The p-diffused region 6 is biased to $V_{op}$ ☐30V through a resistor R. The value of the resistor R amounts to typically a few hundred kilo ohms which is high enough for reliable quenching. The photodiode 18 is produced with a polysilicon field plate 12 as shown in fig. 8, wherein a first end of the polysilicon field plate 12 is connected to $V_{op}$ and wherein a second end of the polysilicon field plate 12 is connected by a first metal line 23 to the p-diffused region 6. The metal line 23 may contact the p-diffused region 6 directly (as shown) or via a p+ doped area. The ohmic resistance of the polysilicon field plate 12 forms the resistor R. The n-well 22 is connected in a standard way via an n+ doped area and a second metal line 24 to the voltage $V_{DD}$.

The p-diffusion region 6 and hence also the second end of the polysilicon field plate 12 is coupled by a capacitor C to an input of a driver 25. The capacitor C is implemented as a metal-to-metal element using the top metal layers: In fig. 14 the capacitor C is formed between a metal layer 26 connected to the first metal line 23 and a metal layer 27 connected to a gate of a PMOS transistor 28 that represents the input of the driver 25. The capacitor C has to withstand a few tens of volts. The driver 25 can be implemented in various ways depending on the system architecture. It can be an inverter, or a common source amplifier or a source follower with one-type transistors (NMOS or PMOS) to save space. The driver 25 is supplied with power $V_{DD}$ relative to GND (ground).

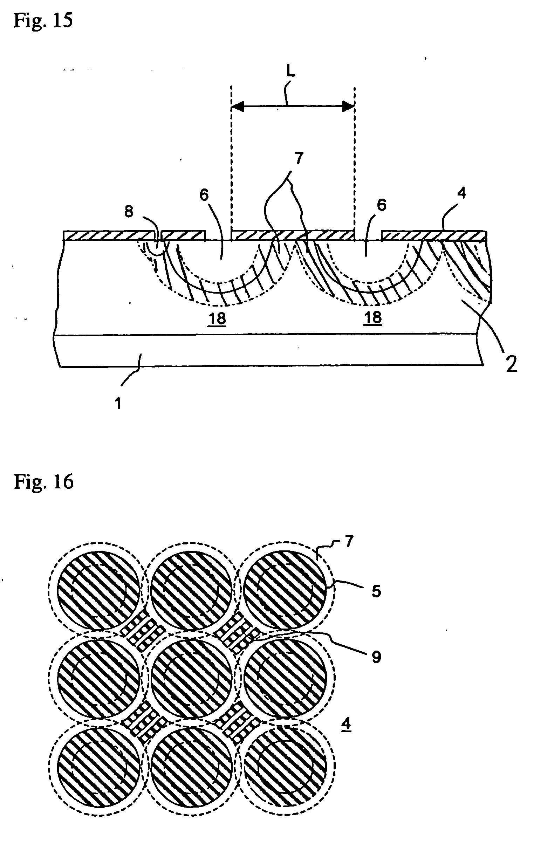

Figs. 15 and 16 illustrate a further concept for increasing the breakdown voltage of photodiodes 18 arranged in a two-dimensional array. Fig. 15 shows a cross-section and fig. 16 shows a plan view of such an array. Each photodiode 18 consists of a region 6 of the second conductivity type embedded in a region of the first conductivity type that is for example a region 2 in the substrate or the substrate itself. The distance L between the boundary of the windows 5 in the implantation mask 4 is selected so that after diffusion and when the whole manufacturing process is completed the depletion zones 7 built up at the pn-junctions touch each other before breakdown occurs, i.e. the depletion zones 7 touch each other at the latest when that reverse bias voltage is applied to the photodiodes 18 at which breakdown occurs. With this concept each photodiode 18, except the photodiodes at the boundary of the array, uses its neighboring photodiodes as guard ring. The photodiodes at the boundary of the array may be guarded in different ways, e.g. as shown for the left outermost photodiode 18 by a mini guard ring 8, a conventional floating diffusion guard ring, a polysilicon or metal field plate or by dummy photodiodes, i.e. photodiodes of the same type but that are not used.

If the photodiodes 18 have a hemispherical structure, as shown in fig. 15, then it is not possible to realize this concept without additional measures because gaps exist between the hemispherical regions. These regions are therefore best filled with additional regions of the second conductivity type that are realized like a mini guard ring in order that their junction depth is the same as the junction depth of a mini guard ring and thus much smaller than the junction depth of the regions 6 of the photodiodes 18. Fig. 16 shows in plan view the implantation mask 4 that has first openings 5 for forming the hemispherical regions 6 and second openings 9 placed in the gaps for forming mini guard stripes. (For the sake of clarity the openings 5 and 9 in the implantation mask 4 are drawn hashed, so that the depletion zone 7 that builds up can be recognized). After the implantation and diffusion step the area below the very near surface is a combined area of the second conductivity type: The doped zones within the second windows 9 that were still separated after the implantation have been combined to a single zone of the second conductivity type during the diffusion process. The junction depth of these zones is the junction depth of a mini guard ring.

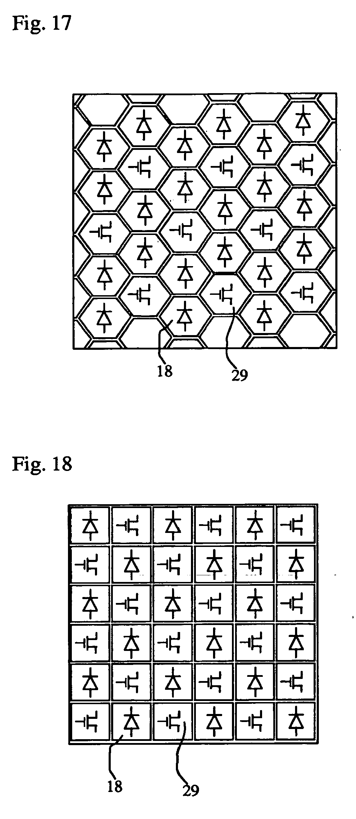

The concept illustrated in figs. 15 and 16 can be extended as shown in figs. 17 and 18 wherein a photodiode 18 uses neighboring photodiodes 18 and/or neighboring electronic circuits 29, e.g. in-pixel electronic circuits, as guard ring. Of course, each electronic circuit 29 is bordered by a depletion zone that isolates the electronic circuit 29 from the substrate. The concept is also applicable if the photodiodes 18 do not have the hemispherical structure of the invention but are conventional photodiodes realized as conventional n-type or p-type well embedded into p-type or n-type material, respectively.

The invention is not limited to CMOS technologies. It may be applied to any other semiconductor technology like e.g. SiGe or GaAs technologies.

**Claims**

1. Semiconductor photodiode with a substantially flat surface, wherein a pn-junction is formed between a region (2) of a first conductivity type and a region (6) of a second conductivity type, wherein the region (6) of the second conductivity type is embedded in the region of the first conductivity type, **characterized in that** the region (6) of the second conductivity type is approximately hemispherical.

2. Semiconductor photodiode according to claim 1, **characterized in that** the region (2) of the first conductivity type is approximately hemispherical.

3. Semiconductor photodiode according to claim 1 or 2, **characterized in that** a mini guard ring (8) surrounds the region (6) of the second conductivity type, wherein

   (1) the mini guard ring (8) is a ring of the second conductivity type that has a junction depth that is at least two times smaller than a junction depth of said pn-junction, or wherein
   (2) the mini guard ring (8) is a ring of the first conductivity type that reduces locally the conductivity of the region (2) of the first conductivity type.

4. Semiconductor photodiode according to any of claims 1 to 3, **characterized in that** a polysilicon plate (12) is placed above and along the periphery of the region (6) of the second conductivity type wherein the polysilicon plate (12) has a first end electrically connected to the region (6) of the second conductivity type.

5. Photodetector comprising at least one semiconductor photodiode (18) according to claim 4 and an electronic circuit (29), the electronic circuit (29) comprising a driver (25), **characterized in that** in operation a second end of the polysilicon plate (12) is biased with a supply voltage that is greater than the breakdown voltage of the semiconductor photodiode (18) and that the first end of the polysilicon plate (12) is coupled to an input of the driver (25) via a capacitor (C).

6. Photodetector (17) comprising a plurality of semiconductor photodiodes (18) according to any of claims 1 to 5, wherein the semiconductor photodiodes (18) are connected in parallel.

7. Array of semiconductor photodiodes (18) as recited in claim 1, **characterized in that** the depletion zones (7) of neighboring photodiodes (18) touch each other before breakdown occurs.

8. Array of semiconductor photodiodes (18) according to claim 7 and further comprising electronic circuits (29) bordered by a depletion zone, **characterized in that** the depletion zones (7) of the photodiodes (18) touch the depletion zones of neighboring photodiodes (18) and/or neighboring electronic circuits (29) before breakdown occurs.

9. Array of semiconductor photodiodes (18) according to claim 7, **characterized in that** the second regions (6) are approximately hemispherical and that mini guard regions of the second conductivity type are placed in areas existing between neighboring photodiodes.

10. Array of semiconductor photodiodes (18) according to claim 8, **characterized in that** the second regions (6) are approximately hemispherical and that mini guard regions of the second conductivity type are placed in areas existing between neighboring photodiodes or electronic circuits (29), respectively.

11. A process for making a semiconductor photodiode (18) with a substantially flat surface, wherein ions of a second conductivity type are implanted through a window (5) in an implantation mask (4) and then diffused into semiconductor material of a first conductivity type for forming a first region (6) of the second conductivity type embedded in the semiconductor material of the first conductivity type, **characterized in that** the lateral dimensions of the window (5) are equal to or smaller than a diffusion length of the ions of the second conductivity type so that the region (6) of the second conductivity type is approximately hemispherical.

12. A process according to claim 11, **characterized in that** ions of the second conductivity type are implanted through a second, ring-shaped window (9) in said implantation mask (4) or another implantation mask that surrounds the first window (5) and then diffused into the semiconductor material of the first conductivity type for forming a second region of the second conductivity type or for reducing locally the conductivity of the region (2) of the first conductivity type, wherein a width of the ring-shaped window (9) is smaller than a maximum lateral dimension of the first window (5) and at least two times smaller than the diffusion length of the ions of the second conductivity type.

13. A process for making a semiconductor photodiode (18) as recited in claim 1, comprising the steps of

- implanting and diffusing ions of a first conductivity type into semiconductor material of a second conductivity type through a first window in a first implantation mask for forming a first region (2) of the first conductivity type wherein the lateral dimensions of the first window are equal to or smaller than a diffusion length of the ions of the first conductivity type, and
- implanting and diffusing ions of the second conductivity type into the first region (2) through a second window in a second implantation mask (4) for forming a second region (6) of the second conductivity type wherein the lateral dimensions of the second window are equal to or smaller than a diffusion length of the ions of the second conductivity type,

wherein the first and second window are centered with respect to each other.

14. A process according to claim 13, **characterized in that** ions of the second conductivity type are implanted through a third, ring-shaped window (9) in the second implantation mask (4) or another implantation mask that surrounds the second window and then diffused into the first region (2) of the first conductivity type for forming a further region of the second conductivity type or for reducing the conductivity of the first region (2) of the first conductivity type below a surface (3), wherein a width of the third, ring-shaped window (9) is smaller than a maximum lateral dimension of the first window and at least two times smaller than the diffusion length of the ions of the second conductivity type.

**Patentansprüche**

1. Halbleiter-Photodiode mit einer im wesentlichen flachen Oberfläche, wobei ein PN-Übergang zwischen einem Gebiet (2) eines ersten Leitfähigkeitstyps und einem Gebiet (6) eines zweiten Leitfähigkeitstyps gebildet ist, wobei das Gebiet (6) des zweiten Leitfähigkeitstyps in das Gebiet des ersten Leitfähigkeitstyps eingebettet ist, **dadurch gekennzeichnet, dass** das Gebiet (6) des zweiten Leitfähigkeitstyps annähernd hemisphärisch ist.

2. Halbleiter-Photodiode nach Anspruch 1, **dadurch gekennzeichnet, dass** das Gebiet (2) des ersten Leitfähigkeitstyps annähernd hemisphärisch ist.

3. Halbleiter-Photodiode nach Anspruch 1 oder 2, **dadurch gekennzeichnet, dass** ein Mini-Schutzring (8) das Gebiet (6) des zweiten Leitfähigkeitstyps umgibt, wobei

   (1) der Mini-Schutzring (8) ein Ring des zweiten Leitfähigkeitstyps ist, der eine Übergangstiefe hat, die wenigstens zweimal kleiner ist als eine Übergangstiefe des genannten PN-Übergangs, oder wobei
   (2) der Mini-Schutzring (8) ein Ring des ersten Leitfähigkeitstyps ist, der lokal die Leitfähigkeit des Gebiets (2) des ersten Leitfähigkeitstyps reduziert.

4. Halbleiter-Photodiode nach einem der Ansprüche 1 bis 3, **dadurch gekennzeichnet, dass** eine Platte (12) aus Polysilizium oberhalb und entlang der Peripherie des Gebiets (6) des zweiten Leitfähigkeitstyps angeordnet ist, wobei die Polysiliziumplatte (12) ein erstes Ende hat, das elektrisch mit dem Gebiet (6) des zweiten Leitfähigkeitstyps verbunden ist.

5. Photodetektor umfassend wenigstens eine Halbleiter-Photodiode (18) gemäß Anspruch 4 und eine elektronische Schaltung (29), wobei die elektronische Schaltung (29) einen Treiber (25) enthält, **dadurch gekennzeichnet, dass** im Betrieb ein zweites Ende der Polysiliziumplatte (12) mit einer Versorgungsspannung vorgespannt wird, die größer als die Durchbruchspannung der Halbleiter-Photodiode (18) ist und dass das erste Ende der Polysiliziumplatte (12) über einen Kondensator (C) an einen Eingang des Treibers (25) gekoppelt ist.

6. Photodetektor (17) umfassend eine Vielzahl von Halbleiter-Photodioden (18) gemäß einem der Ansprüche 1 bis 5, wobei die Halbleiter-Photodioden (18) parallel geschaltet sind.

7. Array von Halbleiter-Photodioden (18) wie im Anspruch 1 definiert, **dadurch gekennzeichnet, dass** die Raumladungszonen (7) benachbarter Photodioden (18) einander berühren bevor ein Durchbruch auftritt.

8. Array von Halbleiter-Photodioden (18) gemäss Anspruch 7 und weiter enthaltend elektronische Schaltkreise (29), die durch eine Raumladungszone begrenzt sind, **dadurch gekennzeichnet, dass** die Raumladungszonen (7) der Photodioden (18) die Raumladungszonen benachbarter Photodioden (18) und/oder benachbarter elektronischer Schaltkreise (29) berühren bevor ein Durchbruch auftritt.

9. Array von Halbleiter-Photodioden (18) gemäss Anspruch 7, **dadurch gekennzeichnet, dass** die zweiten Gebiete (6) annähernd hemisphärisch sind und dass Mini-Schutzringe des zweiten Leitfähigkeitstyps in zwischen benachbarten Photodioden existierenden Gebieten angeordnet sind.

10. Array von Halbleiter-Photodioden (18) gemäss Anspruch 8, **dadurch gekennzeichnet, dass** die zweiten Gebiete (6) annähernd hemisphärisch sind und dass Mini-Schutzringe des zweiten Leitfähigkeitstyps in zwischen benachbarten Photodioden bzw. elektronischen Schaltkreisen (29) existierenden Gebieten angeordnet sind.

11. Verfahren zur Herstellung einer Halbleiter-Photodiode (18) mit einer im wesentlichen flachen Oberfläche, bei dem Ionen eines zweiten Leitfähigkeitstyps durch ein Fenster (5) in einer Implantationsmaske (4) implantiert und dann in Halbleitermaterial eines ersten Leitfähigkeitstyps diffundiert werden, um ein erstes Gebiet (6) des zweiten Leitfähigkeitstyps zu bilden, das in das Halbleitermaterial des ersten Leitfähigkeitstyps eingebettet ist, **dadurch gekennzeichnet, dass** die seitlichen Abmessungen des Fensters (5) gleich gross oder kleiner als eine Diffusionslänge der Ionen des zweiten Leitfähigkeitstyps sind, so dass das Gebiet (6) des zweiten Leitfähigkeitstyps annähernd hemisphärisch ist.

12. Verfahren gemäß Anspruch 11, **dadurch gekennzeichnet, dass** Ionen des zweiten Leitfähigkeitstyps durch ein zweites, ringförmiges Fenster (9) in der genannten Implantationsmaske (4) oder in einer anderen Implantationsmaske, das das erste Fenster (5) umgibt, implantiert und dann in das Halbleitermaterial des ersten Leitfähigkeitstyps diffundiert werden, um ein zweites Gebiet des zweiten Leitfähigkeitstyps zu bilden oder um lokal die Leitfähigkeit des Gebiets (2) des ersten Leitfähigkeitstyps zu reduzieren, wobei eine Breite des ringförmigen Fensters (9) kleiner ist als eine maximale seitliche Abmessung des ersten Fensters (5) und wenigstens zweimal kleiner als die Diffusionslänge der Ionen des zweiten Leitfähigkeitstyps ist.

13. Verfahren zur Herstellung einer Halbleiter-Photodiode (18) wie im Anspruch 1 definiert, umfassend die Schritte

- Ionen eines ersten Leitfähigkeitstyps in Halbleitermaterial eines zweiten Leitfähigkeitstyps durch ein erstes Fenster in einer ersten Implantationsmaske implantieren und die fundieren, um ein erstes Gebiet (2) des ersten Leitfähigkeitstyps zu bilden, wobei die seitlichen Abmessungen des ersten Fensters gleich gross oder kleiner als eine Diffusionslänge der Ionen des ersten Leitfähigkeitstyps sind, und
- Ionen des zweiten Leitfähigkeitstyps durch ein zweites Fenster in einer zweiten Implantationsmaske (4) in das erste Gebiet (2) implantieren und diffundieren, um ein zweites Gebiet (6) des zweiten Leitfähigkeitstyps zu bilden, wobei die seitlichen Abmessungen des zweiten Fensters gleich gross oder kleiner als eine Diffusionslänge der Ionen des zweiten Leitfähigkeitstyps sind,

wobei das erste und zweite Fenster in Bezug aufeinander zentriert sind.

14. Verfahren zur Herstellung einer Halbleiter-Photodiode (18) gemäss Anspruch 13, **dadurch gekennzeichnet, dass** Ionen des zweiten Leitfähigkeitstyps durch ein drittes, ringförmiges Fenster (9) in der zweiten Implantationsmaske (4) oder in einer anderen Implantationsmaske, das das zweite Fenster umgibt, implantiert und dann in das erste Gebiet (2) des ersten Leitfähigkeitstyps diffundiert werden, um ein weiteres Gebiet des zweiten Leitfähigkeitstyps zu bilden oder um die Leitfähigkeit des ersten Gebiets (2) des ersten Leitfähigkeitstyps unterhalb einer Oberfläche (3) zu reduzieren, wobei eine Breite des dritten, ringförmigen Fensters (9) kleiner ist als eine maximale seitliche Abmessung des ersten Fensters und wenigstens zweimal kleiner als die Diffusionslänge der Ionen des zweiten Leitfähigkeitstyps.

**Revendications**

1. Photodiode à semi-conducteurs comportant une surface sensiblement plate, dans laquelle une jonction PN est formée entre une région (2) d'un premier type de conductivité et une région (6) d'un second type de conductivité, dans laquelle la région (6) du second type de conductivité est noyée dans la région du premier type de conductivité, **caractérisée en ce que** la région (6) du second type de conductivité est approximativement hémisphérique.

2. Photodiode à semi-conducteurs selon la revendication 1, **caractérisée en ce que** la région (2) du premier type de conductivité est approximativement hémisphérique.

3. Photodiode à semi-conducteurs selon l'une ou l'autre des revendications 1 et 2, **caractérisée en ce qu'un** mini anneau de garde (8) entoure la région (6) du second type de conductivité, dans laquelle:

(1) le mini anneau de garde (8) est un anneau du second type de conductivité qui a une profondeur de jonction qui est au moins deux fois plus petite qu'une profondeur de jonction de ladite jonction PN, ou dans laquelle (2) le mini anneau de garde (8) est un anneau du premier type de conductivité qui réduit localement la conductivité de la région (2) du premier type de conductivité.

4. Photodiode à semi-conducteurs selon l'une quelconque des revendications 1 à 3, **caractérisée en ce qu'une** plaquette de poly-silicone (12) est placée au-dessus et le long de la périphérie de la région (6) du second type de conductivité, dans laquelle la plaquette de poly-silicone (12) a une première extrémité connectée électriquement à la région (6) du second type de conductivité.

**5.** Détecteur photosensible comprenant au moins une photodiode à semi-conducteurs (18) selon la revendication 4 et un circuit électronique (29), le circuit électronique (29) comprenant un amplificateur (25), **caractérisée en ce qu'une** seconde extrémité de la plaquette de poly-silicone (12) est polarisée pendant le fonctionnement avec une tension d'alimentation qui est plus grande que la tension de claquage de la photodiode à semi-conducteurs (18) et **en ce que** la première extrémité de la plaquette de poly-silicone (12) est accouplée à une entrée de l'amplificateur (25) par l'intermédiaire d'un condensateur (C).

**6.** Détecteur photosensible (17) comprenant une pluralité de photodiodes à semi-conducteurs (18) selon l'une quelconque des revendications 1 à 5, dans lequel les photodiodes à semi-conducteurs (18) sont connectées en parallèle.

**7.** Matrice de photodiodes à semi-conducteurs (18), telles qu'elles sont exposées dans la revendication 1, **caractérisée en ce que** les zones de déplétion (7) des photodiodes avoisinantes (18) se touchent l'une l'autre avant qu'un claquage se produise.

**8.** Matrice de photodiodes à semi-conducteurs (18) selon la revendication 7, et comprenant en outre des circuits électroniques (29) entourés par une zone de déplétion, **caractérisée en ce que** les zones de déplétion (7) des photodiodes (18) touchent les zones de déplétion (7) des photodiodes avoisinantes (18) et/ou les circuits électroniques avoisinants (29) avant qu'un claquage se produise.

**9.** Matrice de photodiodes à semi-conducteurs (18) selon la revendication 7, **caractérisée en ce que** les secondes régions (6) sont approximativement hémisphériques et **en ce que** les régions à mini anneau de garde du second type de conductivité sont placées dans des zones qui existent entre des photodiodes avoisinantes.

**10.** Matrice de photodiodes à semi-conducteurs (18) selon la revendication 8, **caractérisée en ce que** les secondes régions (6) sont approximativement hémisphériques et **en ce que** les régions à mini anneau de garde du second type de conductivité sont placées respectivement dans des zones qui existent entre des photodiodes avoisinantes ou des circuits électroniques (29).

**11.** Processus pour fabriquer une photodiode à semi-conducteurs (18) comportant une surface sensiblement plate, dans lequel des ions d'un second type de conductivité sont implantés à travers une fenêtre (5) dans un masque d'implantation (4) et sont ensuite diffusés dans un matériau semi-conducteur d'un premier type de conductivité pour former une première région (6) du second type de conductivité, noyée dans le matériau semi-conducteur du premier type de conductivité, **caractérisé en ce que** les dimensions latérales de la fenêtre (5) sont égales à ou plus petites qu'une longueur de diffusion des ions du second type de conductivité de telle sorte que la région (6) du second type de conductivité est approximativement hémisphérique.

**12.** Processus selon la revendication 11, **caractérisé en ce que** des ions du second type de conductivité sont implantés à travers une seconde fenêtre de forme annulaire (9) dans ledit masque d'implantation (4) ou dans un autre masque d'implantation qui entoure la première fenêtre (5) et sont ensuite diffusés dans le matériau semi-conducteur du premier type de conductivité pour former une seconde région du second type de conductivité ou pour réduire localement la conductivité de la région (2) du premier type de conductivité, dans lequel une largeur de la fenêtre de forme annulaire (9) est plus petite qu'une dimension latérale maximale de la première fenêtre (5) et est au moins deux fois plus petite que la longueur de diffusion des ions du second type de conductivité.

**13.** Processus pour fabriquer une photodiode à semi-conducteurs (18), telle qu'elle est exposée dans la revendication 1, comprenant les étapes suivantes :

- l'implantation et la diffusion d'ions d'un premier type de conductivité dans un matériau semi-conducteur d'un second type de conductivité à travers une première fenêtre dans un premier masque d'implantation pour former une première région (2) du premier type de conductivité, dans lequel les dimensions latérales de la première fenêtre sont égales à ou plus petites qu'une longueur de diffusion des ions du premier type de conductivité, et
- l'implantation et la diffusion d'ions du second type de conductivité dans la première région (2) à travers une seconde fenêtre dans un second masque d'implantation (4) pour former une seconde région (6) du second type de conductivité, dans lequel les dimensions latérales de la seconde fenêtre sont égales à ou plus petites qu'une longueur de diffusion des ions du second type de conductivité,

dans lequel la première fenêtre et la seconde fenêtre sont centrées l'une par rapport à l'autre.

EP 1 839 343 B1

**14.** Processus selon la revendication 13, **caractérisé en ce que** des ions du second type de conductivité sont implantés à travers une troisième fenêtre de forme annulaire (9) dans le second masque d'implantation (4) ou dans un autre masque d'implantation qui entoure la seconde fenêtre et sont ensuite diffusés dans la première région (2) du premier type de conductivité pour former une autre région du second type de conductivité ou pour réduire la conductivité de la première région (2) du premier type de conductivité en dessous d'une surface (3), dans lequel une largeur de la troisième fenêtre de forme annulaire (9) est plus petite qu'une dimension latérale maximale de la première fenêtre et est au moins deux fois plus petite que la longueur de diffusion des ions du second type de conductivité.

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

Fig. 17

18    29

Fig. 18

18    29

**REFERENCES CITED IN THE DESCRIPTION**

**Patent documents cited in the description**

- US 6376321 B
- WO 03003476 A
- US 20020066860 A
- US 4468684 A

**Non-patent literature cited in the description**

- Avalanche photodiode image sensor in standard silicon BICMOS technology. **Biber A et al.** SENSORS AND ACTUATORS A. ELSEVIER SEQUOIA S.A, 01 May 2001, vol. A90, 82-88
- Monolithically integrated avalanche photodiode and transimpedance amplifier in a hybrid bulk / SOI CMOS process. *Electronic Letters,* February 2003, vol. 39 (4), 391-392
- Single photon detector fabricated in a complementary metal-oxide-semiconductor high-voltage technology. **Rochas A et al.** REVIEW OF SCIENTIFIC INSTRUMENTS. AMERICAN INSTITUTE OF PHYSICS, July 2003, vol. 74, 3263-3270
- First fully integrated 2-D array of single-photon detectors in standard CMOS technology. *IEEE Photonics Technology Letters,* 2003, vol. 15 (7), 963-965
- **S. M. Sze.** Physics of Semiconductor Devices. John Wiley & Sons, Inc, 1981